# EUROPEAN PATENT SPECIFICATION

(11) **EP 2 211 383 B1**
(45) Date of publication and mention of the grant of the patent: **15.03.2017**
(21) Application number: 10250120.2
(22) Date of filing: 25.01.2010
(51) Int. Cl.: H01L 23/373, H01L 23/433, H01L 23/00

(54) **Metal bonded nanotube array**
Anordnung metallgebundener Nanoröhrchen
Réseau métallique de nanotubes liés

(30) Priority: 26.01.2009 US 359662
(43) Date of publication of application: 28.07.2010
(73) Proprietor: The Boeing Company, Chicago, IL 60606-1596 (US)
(72) Inventor: Barvosa-Carter, William B., Woodland Hills, California 91364 (US); Gross, Adam F., California 90405 (US)
(74) Representative: Boult Wade Tennant

(56) References cited:
- JP-A- 2007 009 213
- US-A1- 2004 261 987
- US-A1- 2006 231 946
- US-A1- 2006 258 054
- US-A1- 2007 116 626
- US-A1- 2008 074 847

## Description

### BACKGROUND OF THE INVENTION

The field of the invention relates generally to the transfer of thermal energy away from the source of that energy, and more specifically, to a metal bonded nanotube array.

When the surfaces of a heat sink, such as a copper heat sink or a graphite based chip strap, and a heat source, such as a microprocessor, RADAR array, or MMIC chip, are placed together to create a thermal path, there are microscopic gaps formed by surface roughness between the heat source and the heat sink. Therefore, it is possible that the actual contact area between the two surfaces is very small and little heat may be transferred between the heat source and the heat sink. Current methods to address this problem include a polymer or thermal grease with low thermal conductivity that is placed between the two surfaces to act as a thermal interface material (TIM) that aids thermal transport. The flexible filler creates a much larger contact area between the heat source and heat sink. However this method generally places a low thermal conductivity material (the polymer or thermal grease) between the two high thermal conductivity devices (the heat source and the heat sink)

The above described arrangement results in a thermal bottleneck which can be improved. For example, it would be highly advantageous to use a high thermal conductivity material as the thermal interface material. However, the only high thermal conductivity thermal interface material currently used is solder. When solder is utilized to join a heat source and heat sink the results are not advantageous because the heat sink and heat source must have very similar coefficients of thermal expansion in order to avoid cracking of one or more of the solder interface, the heat source, or the heat sink.

Carbon nanotubes (CNTs) have extremely high thermal conductivities and can act as a thermal interface material that transports heat between a heat sink and a heat source. More specifically, the individual nanotubes are flexible and can bend to accommodate the roughness on the opposing surfaces. In addition, the interface is dry and there is no concern about the TIM flowing out of the gap between the heat source and heat sink as there is with greases and other TIMs. Lastly, when the CNTs are aligned substantially adjacent one another, similar to the strands of a hairbrush, the CNTs are aligned perpendicularly to the substrate and therefore can accommodate differences in thermal expansion by bending perpendicular to the direction along the tubes.

The use of CNTs as a thermal interface material is well known. However, attachment of CNTs to a heat source or heat sink still presents certain issues. For example, there are some cases where CNTs may be grown directly on a heat source or heat sink. However, these cases are few due to the high nanotube growth temperatures of >600 °C that will destroy integrated circuits or damage heat sinks. In all other cases, the CNTs must be grown on a growth substrate and transferred to a heat source or heat sink post fabrication.

US2006231946A1 discloses a thermal interface that includes an array of generally aligned carbon nanotubes joined to a surface with a metal layer.

US2008074847A1 discloses a thermal interface structure which includes a carbon nanotube layer. Metal layers are provided on two edge surfaces of the carbon nanotube layer and the carbon nanotubes are oriented parallel to the direction of thermal transmission.

### BRIEF DESCRIPTION OF THE INVENTION

In one aspect, a method for bonding nano-elements to a surface is described. The method includes applying a layer of a first metal to a first end of a plurality of substantially aligned nano-elements, positioning a layer of a second metal adjacent to the layer of the first metal, positioning a substrate adjacent to the layer of the second metal, placing a compressive force across the nano-elements, the metal layers, and the substrate, and elevating the temperature of the nano-elements, the metal layers, and the substrate such that the metal layers form at least one of a eutectic bond, a metal solid solution, and an alloy bond between the nano-elements and the substrate.

In another aspect, a thermal interface is provided. The thermal interface includes a plurality of substantially aligned nano-elements each having a first end and a second end, a first metal layer bonded to the first ends of the nano-elements, and a second metal layer adjacent the first metal layer and having at least one of a eutectic bond, a metal solid solution, and an alloy bond therebetween that is operable for transferring heat between a heat source and the substantially aligned nano-elements.

In still another embodiment, a structure is provided. The structure includes a plurality of substantially aligned nano-elements each having a first end and a second end, a first metal layer bonded to the first ends of said nano-elements, a second metal layer adjacent said first metal layer, and a substrate. At least one of a eutectic bond, a metal solid solution, and an alloy bond is formed between the nano-elements and the substrate through a compressive force and an elevated temperature across the nano-elements, the metal layers, and the substrate.

### BRIEF DESCRIPTION OF THE DRAWINGS

Figure 1 is an illustration of a carbon nanotube array formed on a silicon substrate and a thermal strap to which the nanotube array is to be bonded.
Figure 2 illustrates deposition of copper and gold onto both the nanotube array and the thermal strap.
Figure 3 illustrates a bonding between the nanotube array and the thermal strap, a cadmium foil placed between the two respective copper/gold layers.
Figure 4 illustrates a eutectic bonding between the nanotube array and a heat sink where the copper/gold layer is deposited on the nanotube array and a layer of indium is deposited on the heat sink.
Figure 5 illustrates the thermal and mechanical attachment of a Gallium Nitrogen device to an aluminum plate.
Figure 6 is a flowchart illustrating a eutectic bonding process.

### DETAILED DESCRIPTION OF THE INVENTION

As utilized herein, a metal eutectic bonded nanotube array is an array of carbon nanotubes (CNTs) that are bonded to a heat source or heat sink using a metal eutectic bond in order to uses nanotubes as a thermal interface material for thermal control of a heat source. Processes that utilize metal solid solution bonding are also considered. As used herein, a eutectic bond describes a melting point of two metals that is less than the metal point of both of the metals. In a metal solid solution bond, the melting point of the two metals is less than the melting point of one of the two metals. While described herein in the context of a eutectic bond, the described embodiments are also operable through metal solid solution bonding.

The process associated with the eutectic bonding processs differs from prior bonding processes in that a eutectic of two or more metals is formed to bond to the tips of a vertically aligned array of CNTs onto a surface that can be the die of a microprocessor/communication chip, a heat sink, or a graphite strap that attaches to a microprocessor. The eutectic bond allows the bonding of nanotubes to another surface to occur at a much lower pressure than the diffusion bonding processes that are currently used.

The use of a eutectic bond between two or more metals allows an attachment between a nanotube array and another substrate to occur at a low pressure. As further described herein, low pressure attachment is desirable because excess (or high) pressure attachment methods may result in a permanently deformed nanotube array. A deformed nanotube array generally will not conform to surface roughness between a heat source and a heat sink. It is also desirable to avoid higher bonding pressures because they may damage a device or heat sink.

Also disclosed herein is the use of a foil in the eutectic bond of one of the two metals and the vacuum deposition of the other metal on one or both of the nanotubes and the new attachment surface (such as the side of a heat sink). The foil can conform to any roughness in the gap between the two surfaces to be bonded while also providing a mechanical bond to both the nanotubes and the attachment surface by being eutectically bonded to both opposing faces.

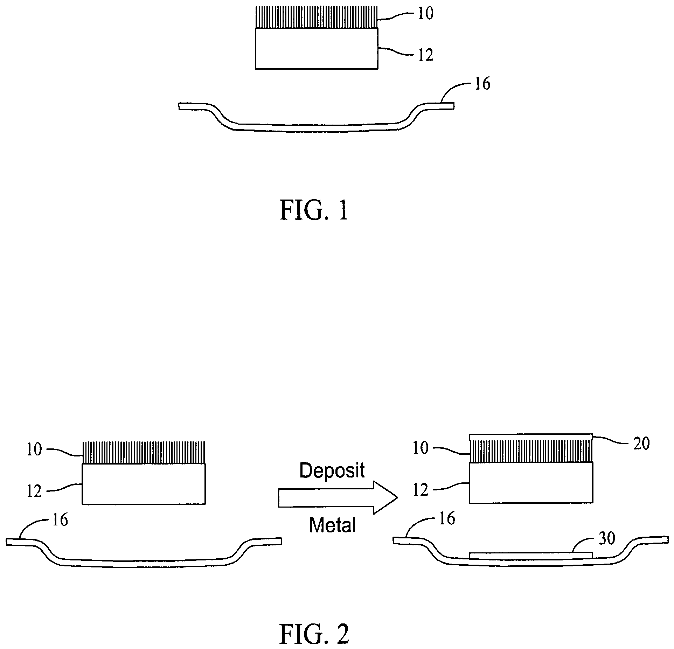

In order to use carbon nanotubes as a thermal interface material, they must be placed in the interface between a heat source and a heat sink. One option is to form nanotubes into a thermal gasket that goes in the interface and the other is to attach the nanotubes to a heat source or a heat sink and have the nanotubes bridge the gap. In both cases, and as shown in Figure 1, the nanotubes 10 are grown on a silicon wafer 12 and must be transferred to another surface, such as thermal strap 16 and subsequently bonded to this surface.

More specifically, in order to bond nanotube array 10 to another surface, the array 10 is first grown on a silicon wafer 12 that has an aluminum blocking layer and a thin iron or nickel catalyst layer deposited on it (these layers are not shown in the figures). This substrate (silicon wafer 12) is heated under hydrogen to first form catalyst nanoparticles from the iron or nickel, and then the nanotubes of the array 10 are grown under flowing organic material (such as ethylene, acetylene, or toluene) and hydrogen. When the gas mixture comes into contact with iron or nickel nanoparticles on the surface of the wafer, carbon nanotubes form. At the end of the growth run a vertically aligned array 10 of nanotubes has been formed on the wafer 12. The array 10 is then transferred onto another substrate that is a heat sink or a heat source.

Metals are highly useful for attaching nanotubes, and therefore nanotube arrays, to another surface. These metals provide a high thermal conductivity bond and may be deposited on a nanotube array and/or the opposing surface through sputtering, evaporation, electrodeposition, chemical vapor deposition (CVD), or metal organic chemical vapor deposition (MOCVD). Figure 2 illustrates a first copper/gold layer 20 that has been deposited onto the carbon nanotube array 10, and a second copper/gold layer 30 that has been deposited onto the thermal strap 16. As further described below, a first layer of a less expensive metal (e.g., copper) may be applied to the nanotube array 10, to immobilize the ends of the individual nano-elements, prior to the application of the metal used to make the eutectic bond (e.g., gold). In the illustrated embodiment, a layer of copper is applied to the nanotube array 10 before the layer of gold is applied.

Metal layers may be attached to one another through a diffusion bond, a solid solution bond, or a eutectic bond. Diffusion bonding bonds two identical metals together by heating the metals near or above the melting point of each of the metals and the atoms from both metals diffuse into one another. One problem associated with diffusion bonding is that it requires high pressure to form the bond. However, eutectic bonding matches two or more metals together where the melting point of the mixture of the combination is lower than a melting temperature of either metal. In solid solution bonding, the melting point of the mixture of the combination is lower than a melting temperature of one of the two metals.

Thus when two metals are pressed together and heated below the melting point of either metal, but above the melting point of the eutectic, they melt together at the interface. This process forms a bond that accommodates any surface roughness between the two surfaces and firmly bonds them together. Another advantage of the eutectic bond is that the local melting where the eutectic is formed requires very low pressures for attachment of opposing faces. A eutectic mixture of two metals has a melting point that is dependant on the composition of the mixture of metals. If a eutectic bond that was made at the minimum melting temperature composition is heated, diffusion of the component metals can occur which will raise the melting point of the bond and render it more temperature stable.

The method by which the metals, for example the above described copper/gold combination, are placed on the nanotube array 10 controls if attachment is successful. For example, if a thin metal foil is placed between the nanotube array 10 and the opposing surface of thermal strap 16, or if a thin metal layer is deposited on the opposing surface but not onto the nanotube array 10, when the sandwich of nanotubes, metal foil, and the other surface is heated, the metal may melt but may not infiltrate into the nanotube array 10. Thus no bond will be created. A bond will only be formed if a metal layer, such as copper/gold layer 20, is first deposited onto the nanotube array 10 which operates to immobilize the tips of the individual nanotubes. Next this metal layer is bonded onto an opposing surface that contains a metal that will form a eutectic with the metal coated array of nanotubes. As described herein, the opposing surface is generally a heat source, a heat sink, or another metalized nanotube array. In all the described embodiments, the metal bonding is performed through creation of a metal-metal eutectic.

A foil is not always used. One embodiment is formed by depositing one metal on top of the nanotubes array 10 and depositing a different metal that will form the eutectic is deposited on top of the opposing surface (thermal strap 16) that will be bonded to the nanotubes array. Then the bond is created by heating the nanotube array 10 held against the opposing surface (thermal strap 16) above the eutectic melting temperature. In one specific embodiment, the opposing surface is a pyrolytic graphite thermal strap.

In another embodiment, the bond is formed by depositing one metal on top of the nanotube array 10 and placing a foil of another metal that will form the eutectic (and wets the opposing surface) between the nanotubes and the opposing surface. Then the bond is created by heating the nanotube array 10 and holding it against the opposing surface with the foil between the two, with the heating bringing the combination above the eutectic melting temperature.

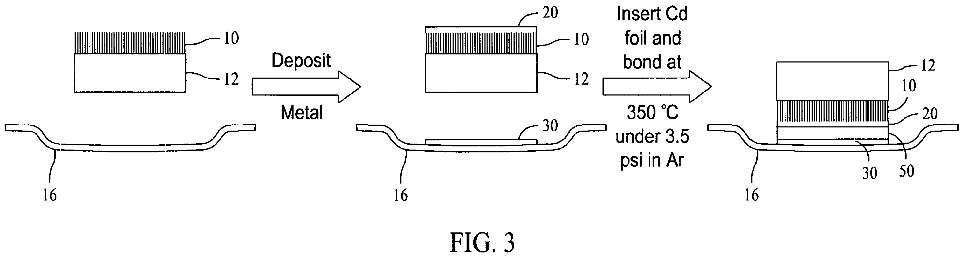

Yet another embodiment is created by depositing one metal onto the nanotube array 10 and also onto the opposing surface (thermal strap 16) that will be bonded to the nanotube array 10. This embodiment is shown in Figure 3. A foil 50 of a second metal, in the illustrated embodiment cadmium, that will form the eutectic is placed between the coated nanotube array 10 and the coated thermal strap 16 (the opposing surface). Then the eutectic bond is created by heating the assembly while holding the nanotube array against the opposing surface, the foil 50 in between, to a temperature that is above the eutectic melting temperature though not shown, after the bond is made, the silicon wafer 12 may be removed.

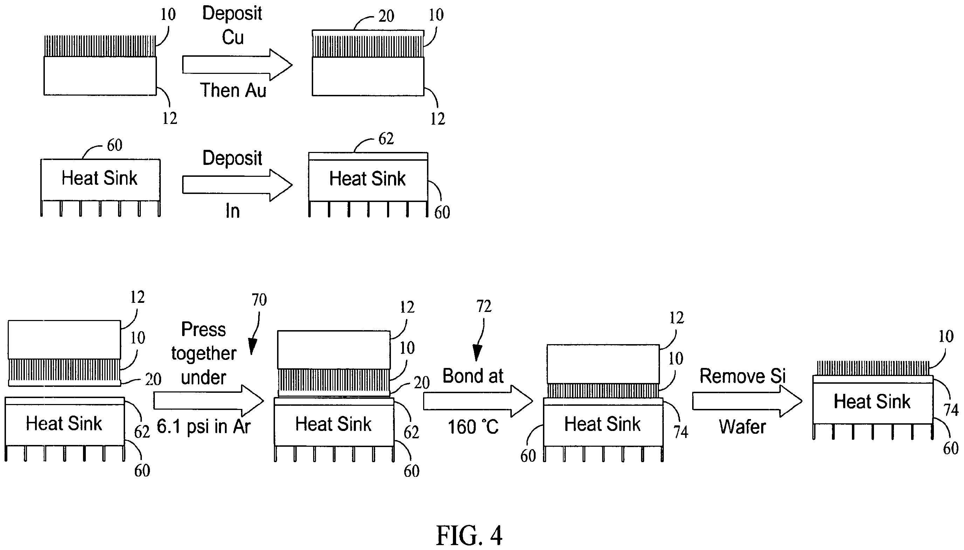

A foil is not always used as illustrated in Figure 4. Figure 4 illustrates a eutectic bonding between the nanotube array 10 and a heat sink 60 where the copper/gold layer 20 is deposited on the nanotube array 10 and a layer of indium 62 is deposited on the heat sink 60. More generally, one metal is deposited on top of the nanotube array 10 and a different metal that will form the eutectic is deposited on top of the opposing surface, such as the heat sink 60, that is to be bonded to the nanotube array 10. As shown, the bond is subsequently created by holding 70 the nanotube array 10 against the opposing surface (heat sink 60) and applying 72 heat at a temperature that is at or slightly above the eutectic melting temperature. In one embodiment the bond is created in an argon environment, with a pressure of about 6.1 psi used. For the particular metals described with respect to Figure 4, the temperature is about 160 degrees Celsius. After the bonding is complete, and the eutectic 74 is formed, the silicon substrate 12 may be removed.

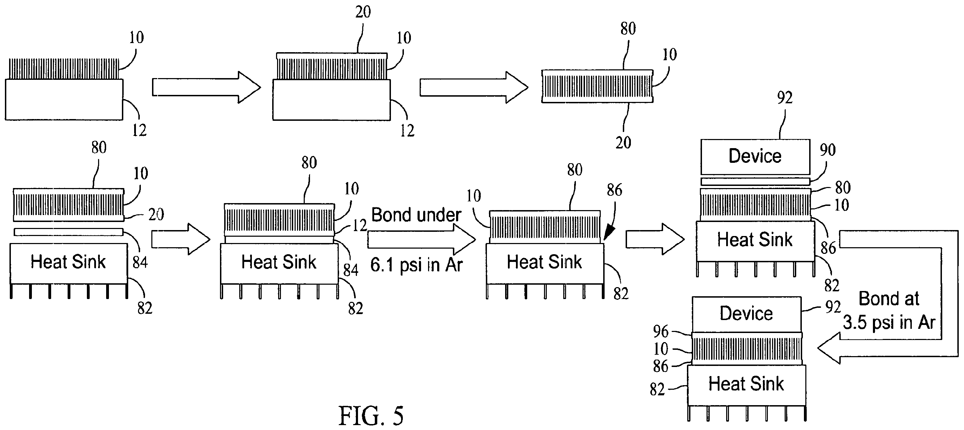

In a further example, illustrated in Figure 5, a Gallium Nitrogen device is attached thermally and mechanically to an aluminum plate that is a substitute for an aluminum electronics housing. As in the prior Figures, four microns of copper and then one micron of gold (e.g., layer 20) was deposited onto the top of the carbon nanotube array 10 which was fabricated on the silicon wafer 12. The carbon nanotube array 10 was separated from the silicon wafer 12, for example with a razor blade, and the array 10 was flipped over so that the uncoated ends of the nanotube array 10 were exposed. Four microns of copper and then one micron of gold was deposited onto the carbon nanotube array 10 to form layer 80.

The aluminum plate (heat sink 82) was coated with 20 nanometers of titanium as an adhesion layer, then four microns of copper and then one micron of gold. A fifty micron think indium foil 84 was placed between the nanotube metalized gasket and the aluminum plate and 6.1 psi was applied. The stack was heated to 180°C, while under the pressure to melt the indium. The indium formed a solid solution (eutectic 86) with the gold deposited on the nanotubes 10 and on the heat sink 82. Then a second fifty micron thick Indium foil 90 was placed between the Gallium Nitrogen device 92 and the carbon nanotube array 10/heatsink 82 assembly and 3.5 psi was applied and the entire assembly was heated to 180°C to form eutectic bond 96.

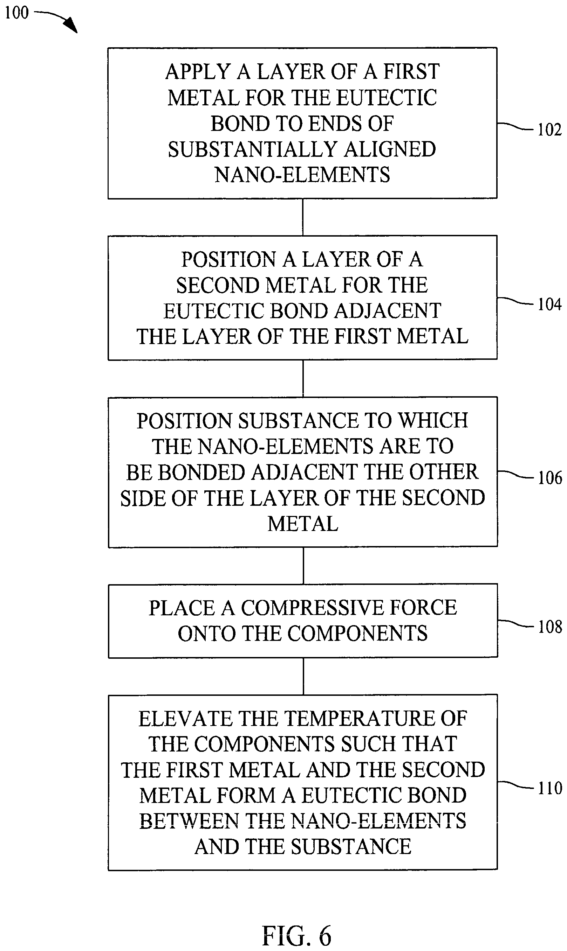

Figure 6 is a flowchart 100 that further illustrates at a high level the methods by which the above described thermal interfaces and below described examples are fabricated. Specifically, flowchart 100 illustrates a method for bonding nano-elements to a surface. The method includes applying 102 a layer of a first metal for the eutectic bond to a first end of substantially aligned nano-elements. A layer of a second metal for the eutectic bond is positioned 104 adjacent to the layer of the first metal. The substance, sometimes referred to as a substrate, to which the nano-elements are to be bonded is positioned 106 adjacent to the other side of the layer of the second metal. A compressive force is then placed 108 across the nano-elements, the metal layers, and the substrate which are collectively referred to as the components. The temperature of the components is then elevated 110 such that the first metal and the second metal layers form a eutectic bond between the nano-elements and the substance.

A couple of examples further illustrate the above described eutectic bonding embodiments. In the first example, a 100 micron tall, one square centimeter carbon nanotube array and a pyrolytic graphite thermal strap for holding a microprocessor and transporting heat out of it are both first coated with four microns copper and then one micron of gold. A 0.001" cadmium foil 50 is placed between the metalized nanotube tips and the metalized graphite thermal strap. Three and one-half pounds per square inch of pressure is applied and the assembly was heated to 350°C, in an Argon atmosphere for about 45 minutes. The sample was cooled and the nanotubes were found to be well bonded to the graphite stack. Subsequently, the silicon wafer was easily removed from the other side of the nanotube array. In the embodiment first embodiment, the melting point of Au is in excess of 1000°C, the melting point of Cadmium is 321 °C, and the minimum melting point of a Cd-Au eutectic is about 308 °C. The bottom copper layer is deposited because it is inert and is more cost effective than depositing five microns of gold.

Another attempt at eutectic bonding was made were the carbon nanotube array was pressed into the graphite thermal strap with only with a gold foil, and a cadmium foil in between. The foils created a eutectic but the carbon nanotube array was not infiltrated by the metals and no bonding occurred.

In the another example, a 100 micron tall, one square centimeter carbon nanotube array and a copper plate that is a substitute for a copper heat sink are both coated, first with first five microns of copper and then with five microns of indium. A 0.001" Cadmium foil is placed between the metalized nanotube tips and the metal (indium) coated copper. 3.5 psi was applied and the assembly was heated to 120 °C in an Argon atmosphere for about 45 minutes. The melting point of Indium is about 157 °C, the melting point of Cadmium is about 321 °C, and the minimum melting point of a Cadmium-Indium eutectic is about 78 °C. Once this sample was cooled, the nanotubes were found to be well bonded to the copper while the silicon wafer was easily removed from the other side of the nanotube array.

The result of this example illustrates the advantage of using eutectic bonds due to the low required pressures and temperatures as compared to diffusion bonds. In comparison, a 100 micron tall, one square centimeter carbon nanotube array and a copper plate that is a substitute for a copper heat sink are both coated first with five microns of copper and then five microns of indium. To bond the indium faces together the array required heating to 160 °C in an Argon atmosphere for 45 minutes but with a pressure of 26 psi. The higher pressure resulted in delaminating of the two metalized faces. In addition, the high pressure applied for bonding made it difficult to remove the silicon nanotube growth substrate from the other end of the array as the nanotubes were compressed into a shiny black surface. Such compression makes it difficult for the nanotubes to conform to surface roughness as a thermal interface material.

In a third example, a 100 micron tall, one square centimeter carbon nanotube array was first coated with five microns of copper and then with five microns of indium. A 0.001 inch Cadmium foil was placed between the metalized nanotube tips and a piece of uncoated copper plate. 3.5 psi was applied and the stack was heated to 120 °C in an Argon atmosphere for 45 minutes. The melting point of indium is 157 °C, the melting point of cadmium is 321 °C, and the minimum melting point of a cadmium-indium eutectic is 78 °C. After the sample was cooled, the nanotubes were found to be well bonded to the copper, and the silicon wafer was easily removed from the other side of the nanotube array.

In yet another example, an indium/gold solid solution (which is similar to a eutectic, but having a variable composition, was used to attach carbon nanotubes to a pyrolytic graphite thermal chip cooling strap, within an argon environment. Four microns of copper and then one micron of gold was deposited onto the top of the carbon nanotube array. A fifty micron thick indium foil was placed between the array and the thermal strap. To make the bond 6.1 psi was applied, the stack was heated to 180°C, while under the pressure to melt the indium. The indium formed a solid solution with the gold deposited on the nanotubes and also wetted the thermal strap. The liquid metal bond was cooled and the silicon wafer base was eventually removed from the nanotubes.

In a final example, a self soldering foil was used to attach carbon nanotubes to the thermal strap. This example was processed in an argon environment, but argon is not required and the process can be performed in an air environment. In this example, five microns of copper and then five microns of indium are deposited onto the top of a carbon nanotube array and also onto on the thermal strap. A self-soldering foil is placed between the metal coated carbon nanotube array and the metal coated thermal strap. In one preferred embodiment, the foil is a forty micron thick foil, such as is provided by Reactive NanoTechnologies. To make the bond, the silicon-carbon nanotube-foil stack is held together with two binder clips, and the foil is liquified with an electric pulse from a nine volt battery. The silicon wafer base is then removed from the carbon nanotubes. No eutectic is formed, however, the example illustrates another bonding method that can be utilized to form a low temperature, low pressure bond.

It is important to understand that while the described embodiments refer to the bonding of carbon nanotubes to surfaces through eutectic bonds, the disclosure should not be considered to be limited to only carbon nanotubes. Instead the embodiments are also applicable to boron nitride nanotubes, boron nanotubes or nanofibers, silicon nanorods, and aluminum nitride nanotubes or nanofibers. Additional possible eutectic mixtures or metals for bonding include silver/bismuth, silver/cadmium, silver/indium, gold/bismuth, gold/cadmium, gold/germanium, gold/indium, gold/tin, indium/tin, copper/tin, bismuth/cadmium, bismuth/indium, cadmium/copper, and indium/zinc.

The above described embodiments refer to the use of metal foils to produce a low temperature bond between a carrier substrate and an array of nanotubes, for example, carbon nanotubes. In one specific embodiment, the nanotubes have a vapor deposition of a first metal thereon at one end to enable a eutectic bond to a second metal placed between the nanotubes and a carrier substrate. Depending on the material selection, the bonding of the nanotubes with the carrier substrate may be improved if a layer of the first metal is first deposited onto the carrier substrate.

The use of the metal foils enables a bond between the nanotubes (CNT) and the substrate to create a highly efficient thermal interface that is produced utilizing relatively low processing temperatures. Current methods, such as diffusion bonding require direct carbon nanotube growth to the substrate at high temperatures (>600°C). The exposure to such temperatures causes damage to sensitive parts and/or provides an inferior solution. The described processes allows for processing at lower temperatures (<100°C) and results in an improved heat transfer, for example, from a die processing chip. Such embodiments likely have application, for example, in electronics applications where heat removal is required.

Heat removal limits processing power in various applications, such as missiles and satellites, however there are many other applications where heat removal remains a problem that impacts over all performance. The use of improved thermal interface materials enables greater processing capabilities and longer product lifetimes by reducing system temperature in these products. Finally, the described embodiments enable increased heat removal from power electronics and electronics boxes in both vehicles and non-mobile devices.

## Claims

1. A method for bonding nano-elements to a surface (10), said method comprising:
applying layers of metal (20) onto a top of a nano-element array (10) of plurality of substantially aligned nano-elements, the layers of the metal (20) including a layer of an inert metal bonded to tips of the plurality of aligned nano-elements (10) to immobilize the ends of the individual nano-elements and a first layer of a first active metal applied onto the layer of the inert metal;
positioning a second layer (30) of a second active metal between the first layer of the first active metal and a substrate (16);
placing a compressive force across the nano-elements (10), the metal layers (20, 30), and the substrate; and
elevating the temperature of the nano-elements (10), the metal layers (20, 30), and the substrate (16) such that the first and second active metals form at least one of a eutectic bond, a metal solid solution, and an alloy bond between the nano-elements and the surface.

2. A method according to Claim 1 wherein applying layers of metal (20) comprises applying the first layer of the first active metal that includes at least one of gold, silver, bismuth, copper, tin, germanium, cadmium, indium, and zinc.

3. A method according to Claim 2 wherein positioning a layer of a second active metal (30) comprises applying a layer of at least one of gold, silver, bismuth, copper, tin, germanium, cadmium, indium, and zinc, the second layer being different a different metal than the first layer.

4. A method according to Claim 1 further comprising growing a plurality of substantially aligned nano-elements (10) on a silicon wafer.

5. A method according to Claim 4 further comprising removing the silicon wafer from the eutectically bonded nano-elements.

6. A method according to Claim 1 wherein applying layers of metal (20) onto a top of a nano-element array (10) of a plurality of substantially aligned nano-elements comprises immobilizing the ends of individual nano-elements.

7. A method according to Claim 1 wherein:
applying layers of metal (20) comprises applying layers of metal utilizing a deposition process; and
positioning a second layer (30) of a second active metal comprises placing a thin foil of the second active metal adjacent to the first active metal.

8. A method according to Claim 1 further comprising:
depositing a second layer of the first active metal onto a substrate (16); and
placing the layer of the second active metal between the second layer of the first active metal on the substrate (16) and the first layer of the first active metal on the nano-elements (10).

9. A method according to Claim 1 wherein:
applying layers of metal (20) onto a top of a nano-element array (10) of a plurality of substantially aligned nano-elements comprises applying the first layer of the first active metal that that includes a layer of gold to the ends of a plurality of substantially aligned carbon nanotubes; and
positioning a second layer of a second active metal (30) adjacent to the layer of the first metal comprises placing a layer of cadmium adjacent to the layer of gold.

10. A method according to Claim 1 wherein applying layers of metal (20) onto a top of a nano-element array (10) of a plurality of substantially aligned nano-elements comprises applying a layers of metal to a first end of a plurality of at least one of substantially aligned carbon nanotubes, substantially aligned boron nitride nanotubes, substantially aligned boron nanotubes, substantially aligned boron nanofibers, substantially aligned silicon nanorods, substantially aligned aluminum nitride nanotubes, and substantially aligned aluminum nitride nanofibers.

11. A method according to Claim 1 wherein positioning a layer of a second active metal (30) adjacent to the first layer of the first active metal comprises:
applying the second active metal to a substrate (16); and
positioning the substrate (16) such that the first active metal and the second active metal are adjacent.

12. A method according to Claim 1 further comprising:
applying a layer of the first metal (80) to a second end of the plurality of substantially aligned nano-elements (10); and
positioning a layer of the second metal (84) adjacent to the layer of the first metal.

13. A thermal interface comprising:
nano-element array (10) of a plurality of substantially aligned nano-elements each having a first end and a second end;
an inert metal bonded to the tips of the plurality of aligned nano-elements (10) to immobilize the ends of the individual nano-elements;
a first metal layer (20) of a first active metal on the inert metal; and
a second metal layer (30) of a second active metal adjacent said first metal layer of a first active metal and having at least one of a eutectic bond, a metal solid solution, and an alloy bond therebetween operable for transferring heat between a heat source and the substantially aligned nano-elements.

14. A thermal interface according to Claim 13 wherein said nano-element array (10) of a plurality of substantially aligned nano-elements comprise at least one of carbon nanotubes, boron nitride nanotubes, boron nanotubes, boron nanofibers, silicon nanorods, aluminum nitride nanotubes, and aluminum nitride nanofibers.

15. A thermal interface according to Claim 14 wherein:
the first metal layer (20) comprises at least one of gold, silver, bismuth, copper, tin, germanium, cadmium, indium, and zinc; and
the second metal layer (30) comprises at least one of gold, silver, bismuth, copper, tin, germanium, cadmium, indium, and zinc, the second layer being different a different metal than the first layer.

16. A thermal interface according to Claim 13 further comprising a third metal layer comprising the same metal as the first metal layer (20), the third metal deposited onto the heat source, the second metal layer (30) between the first (20) and the third metal layers.

## Patentansprüche

1. Verfahren zum Verbinden von Nanoelementen mit einer Oberfläche (10) wobei das Verfahren umfasst:
Aufbringen von Metallschichten (20) auf eine Oberseite einer Nanoelementanordnung (10) aus mehreren im Wesentlichen ausgerichteten Nanoelementen, wobei die Metallschichten (20) eine Schicht aus einem inerten Metall, das mit den Spitzen der mehreren ausgerichteten Nanoelemente (10) verbunden ist, um die Enden der einzelnen Nanoelemente zu immobilisieren, und eine erste Schicht aus einem ersten aktiven Metall umfassen, die auf die Schicht aus dem inerten Metall aufgebracht ist;
Anordnen einer zweiten Schicht (30) aus einem zweiten aktiven Metall zwischen der ersten Schicht aus dem ersten aktiven Metall und einem Substrat (16);
Ausüben einer Druckkraft auf die Nanoelemente (10), die Metallschichten (20, 30) und das Substrat; und
Erhöhen der Temperatur der Nanoelemente (10), der Metallschichten (20, 30) und des Substrats (16) so, dass das erste und das zweite aktive Metall zwischen den Nanoelementen und der Oberfläche eine eutektische Verbindung und/oder eine Metallmischkristalllösung und/oder eine Legierungsverbindung ausbilden.

2. Verfahren nach Anspruch 1, wobei das Aufbringen von Metallschichten (20) ein Aufbringen der ersten Schicht aus dem ersten aktiven Metall umfasst, das Gold und/oder Silber und/oder Bismut und/oder Kupfer und/oder Zinn und/oder Germanium und/oder Cadmium und/oder Indium und/oder Zink enthält.

3. Verfahren nach Anspruch 2, wobei ein Anordnen einer Schicht aus einem zweiten aktiven Metall (30) ein Aufbringen einer Schicht aus Gold und/oder Silber und/oder Bismut und/oder Kupfer und/oder Zinn und/oder Germanium und/oder Cadmium und/oder Indium und/oder Zink umfasst, wobei sich das Metall der zweiten Schicht von dem der ersten Schicht unterscheidet.

4. Verfahren nach Anspruch 1, das ferner ein Aufwachsen von mehreren im Wesentlichen ausgerichteten Nanoelementen (10) auf einem Siliciumwafer umfasst.

5. Verfahren nach Anspruch 4, das ferner ein Entfernen des Siliciumwafers von den eutektisch verbundenen Nanoelementen umfasst.

6. Verfahren nach Anspruch 1, wobei ein Aufbringen von Metallschichten (20) auf eine Oberseite einer Nanoelementanordnung (10) aus mehreren im Wesentlichen ausgerichteten Nanoelementen ein Immobilisieren der Enden einzelner Nanoelemente umfasst.

7. Verfahren nach Anspruch 1, wobei:
ein Aufbringen von Metallschichten (20) ein Aufbringen von Metallschichten unter Verwendung eines Abscheideprozesses umfasst; und
ein Anordnen einer zweiten Schicht (30) aus einem zweiten aktiven Metalls umfasst, dass eine dünne Folie des zweiten aktiven Metalls an das erste aktive Metall angrenzend platziert wird.

8. Verfahren nach Anspruch 1, das ferner aufweist:
Abscheiden einer zweiten Schicht des ersten aktiven Metalls auf einem Substrat (16); und
Platzieren der Schicht aus dem zweiten aktiven Metall zwischen der zweiten Schicht aus dem ersten aktiven Metall auf dem Substrat (16) und der ersten Schicht aus dem ersten aktiven Metall auf den Nanoelementen (10).

9. Verfahren nach Anspruch 1, wobei:
ein Aufbringen von Metallschichten (20) auf eine Oberseite einer Nanoelementanordnung (10) aus mehreren im Wesentlichen ausgerichteten Nanoelementen ein Aufbringen der ersten Schicht aus dem ersten aktiven Metall, die eine Goldschicht aufweist, auf die Enden mehrerer im Wesentlichen ausgerichteter Kohlenstoff-Nanoröhrchen umfasst; und
ein an die Schicht aus dem ersten Metall angrenzendes Anordnen einer zweiten Schicht aus einem zweiten aktiven Metall (30) ein an die Goldschicht angrenzendes Platzieren einer Cadmiumschicht umfasst.

10. Verfahren nach Anspruch 1, wobei ein Aufbringen von Metallschichten (20) auf eine Oberseite einer Nanoelementanordnung (10) aus mehreren im Wesentlichen ausgerichteten Nanoelementen ein Aufbringen einer Metallschicht auf ein erstes Ende von mehreren im Wesentlichen ausgerichteten Kohlenstoff-Nanoröhrchen und/oder im Wesentlichen ausgerichteten Bornitrid-Nanoröhrchen und/oder im Wesentlichen ausgerichteten Bor-Nanoröhrchen und/oder im Wesentlichen ausgerichteten Bor-Nanofasern und/oder im Wesentlichen ausgerichteten Silicium-Nanostäbchen und/oder im Wesentlichen ausgerichteten Aluminiumnitrid-Nanoröhrchen und/oder im Wesentlichen ausgerichteten Aluminiumnitrid-Nanofasern umfasst.

11. Verfahren nach Anspruch 1, wobei ein an die erste Schicht aus einem ersten aktiven Metall angrenzendes Anordnen einer Schicht aus einem zweiten aktiven Metall (30) umfasst:
Aufbringen des zweiten aktiven Metalls auf ein Substrat (16); und
Anordnen des Substrats (16) so, dass das erste aktive Metall und das zweite aktive Metall aneinander angrenzen.

12. Verfahren nach Anspruch 1, das ferner umfasst:
Aufbringen einer Schicht des ersten Metalls (80) auf ein zweites Ende der mehreren im Wesentlichen ausgerichteten Nanoelemente (10); und
an die Schicht aus dem erstem Metall angrenzendes Anordnen einer Schicht des zweiten Metalls (84).

13. Thermische Grenzfläche, die aufweist:
eine Nanoelementanordnung (10) aus mehreren im Wesentlichen ausgerichteten Nanoelementen, die jeweils ein erstes Ende und ein zweites Ende aufweisen;
ein mit den Spitzen der mehreren ausgerichteten Nanoelemente (10) verbundenes inertes Metall zum Immobilisieren der Enden der einzelnen Nanoelemente;
eine auf dem inerten Metall angeordnete erste Metallschicht (20) aus einem ersten aktiven Metall; und
eine zweite Metallschicht (30) aus einem zweiten aktiven Metall, die an die erste Matallschicht aus einem ersten aktiven Metall angrenzt, wobei zwischen diesen eine eutektische Verbindung und/oder eine Metallmischkristalllösung und/oder eine Legierungsverbindung ausgebildet ist, die zur Übertragung von Wärme zwischen einer Wärmequelle und den im Wesentlichen ausgerichteten Nanoelementen einsetzbar ist.

14. Thermische Grenzfläche nach Anspruch 13, wobei die Nanoelementanordnung (10) aus mehreren im Wesentlichen ausgerichteten Nanoelementen Kohlenstoff-Nanoröhrchen und/oder Bornitrid-Nanoröhrchen und/oder Bor-Nanoröhrchen und/oder Bor-Nanofasern und/oder Silicium-Nanostäbchen und/oder Aluminiumnitrid-Nanoröhrchen und/oder Aluminiumnitrid-Nanofasern aufweist.

15. Thermische Grenzfläche nach Anspruch 14, wobei
die erste Metallschicht (20) Gold und/oder Silber und/oder Bismut und/oder Kupfer und/oder Zinn und/oder Germanium und/oder Cadmium und/oder Indium und/oder Zink enthält; und
die zweite Metallschicht (30) Gold und/oder Silber und/oder Bismut und/oder Kupfer und/oder Zinn und/oder Germanium und/oder Cadmium und/oder Indium und/oder Zink enthält, wobei sich das Metall der zweiten Schicht von dem der ersten Schicht unterscheidet.

16. Thermische Grenzfläche nach Anspruch 13, die ferner eine dritte Metallschicht aufweist, die dasselbe Metall wie die erste Metallschicht (20) enthält, das dritte Metall auf der Wärmequelle abgeschieden ist und sich die zweite Metallschicht (30) zwischen der ersten (20) und der dritten Metallschicht befindet.

## Revendications

1. Procédé de liaison de nano-éléments à une surface (10), ledit procédé comprenant les étapes consistant à :
appliquer des couches de métal (20) sur un dessus d'un réseau de nano-éléments (10) constitué d'une pluralité de nano-éléments sensiblement alignés, les couches de métal (20) comprenant une couche d'un métal inerte liée à des pointes de la pluralité de nano-éléments alignés (10) pour immobiliser les extrémités des nano-éléments individuels, et une première couche d'un premier métal actif appliquée sur la couche du métal inerte ;
positionner une deuxième couche (30) d'un deuxième métal actif entre la première couche du premier métal actif et un substrat (16) ;
exercer une force de compression à travers les nano-éléments (10), les couches de métal (20, 30) et le substrat ; et
élever la température des nano-éléments (10), des couches de métal (20, 30) et du substrat (16) de telle sorte que les premier et deuxième métaux actifs forment au moins l'une d'une liaison eutectique, d'une solution solide de métal, et d'une liaison d'alliage entre les nano-éléments et la surface.

2. Procédé selon la revendication 1, dans lequel l'application de couches de métal (20) comprend l'application de la première couche du premier métal actif qui comprend au moins l'un de l'or, l'argent, le bismuth, le cuivre, l'étain, le germanium, le cadmium, l'indium et le zinc.

3. Procédé selon la revendication 2, dans lequel le positionnement d'une couche d'un deuxième métal actif (30) comprend l'application d'une couche d'au moins l'un de l'or, l'argent, le bismuth, le cuivre, l'étain, le germanium, le cadmium, l'indium et le zinc, la deuxième couche étant différente, d'un métal différent de la première couche.

4. Procédé selon la revendication 1, comprenant en outre la croissance d'une pluralité de nano-éléments sensiblement alignés (10) sur une plaquette de silicium.

5. Procédé selon la revendication 4, comprenant en outre le retrait de la plaquette de silicium depuis les nano-éléments liés de manière eutectique.

6. Procédé selon la revendication 1, dans lequel l'application de couches de métal (20) sur un dessus d'un réseau de nano-éléments (10) constitué d'une pluralité de nano-éléments sensiblement alignés comprend l'immobilisation des extrémités de nano-éléments individuels.

7. Procédé selon la revendication 1, dans lequel :
l'application de couches de métal (20) comprend l'application de couches de métal en utilisant un procédé de dépôt ; et
le positionnement d'une deuxième couche (30) d'un deuxième métal actif comprend la mise en place d'une feuille mince du deuxième métal actif adjacente au premier métal actif.

8. Procédé selon la revendication 1, comprenant en outre les étapes consistant à :
déposer une deuxième couche du premier métal actif sur un substrat (16) ; et
placer la couche du deuxième métal actif entre la deuxième couche du premier métal actif sur le substrat (16) et la première couche du premier métal actif sur les nano-éléments (10).

9. Procédé selon la revendication 1, dans lequel :
l'application de couches de métal (20) sur un dessus d'un réseau de nano-éléments (10) constitué d'une pluralité de nano-éléments sensiblement alignés comprend l'application de la première couche du premier métal actif qui comprend une couche d'or aux extrémités d'une pluralité de nanotubes de carbone sensiblement alignés ; et
le positionnement d'une deuxième couche d'un deuxième métal actif (30) adjacente à la couche du premier métal comprend le placement d'une couche de cadmium adjacente à la couche d'or.

10. Procédé selon la revendication 1, dans lequel l'application de couches de métal (20) sur un dessus d'un réseau de nano-éléments (10) constitués d'une pluralité de nano-éléments sensiblement alignés comprend l'application d'une couche de métal à une première extrémité d'une pluralité d'au moins certains de nanotubes de carbone sensiblement alignés, de nanotubes de nitrure de bore sensiblement alignés, de nanotubes de bore sensiblement alignés, de nano-fibres de bore sensiblement alignées, de nano-tiges de silicium sensiblement alignées, de nanotubes de nitrure d'aluminium sensiblement alignés et de nano-fibres de nitrure d'aluminium sensiblement alignées.

11. Procédé selon la revendication 1, dans lequel le positionnement d'une couche d'un deuxième métal actif (30) adjacente à la première couche du premier métal actif comprend :
l'application du deuxième métal actif sur un substrat (16) ; et
le positionnement du substrat (16) de telle sorte que le premier métal actif et le deuxième métal actif soient adjacents.

12. Procédé selon la revendication 1, comprenant en outre les étapes consistant à :
appliquer une couche du premier métal (80) à une deuxième extrémité de la pluralité de nano-éléments sensiblement alignés (10) ; et
positionner une couche du deuxième métal (84) adjacente à la couche du premier métal.

13. Interface thermique comprenant :
un réseau de nano-éléments (10) constitués d'une pluralité de nano-éléments sensiblement alignés ayant chacun une première extrémité et une deuxième extrémité ;
un métal inerte lié aux pointes de la pluralité de nano-éléments alignés (10) pour immobiliser les extrémités des nano-éléments individuels ;
une première couche de métal (20) d'un premier métal actif sur le métal inerte ; et
une deuxième couche de métal (30) d'un deuxième métal actif adjacente à ladite première couche de métal d'un premier métal actif et ayant au moins l'une d'une liaison eutectique, d'une solution solide de métal et d'une liaison d'alliage entre celles-ci, opérationnelle pour transférer de la chaleur entre une source de chaleur et les nano-éléments sensiblement alignés.

14. Interface thermique selon la revendication 13, dans laquelle ledit réseau de nano-éléments (10) constitué d'une pluralité de nano-éléments sensiblement alignés comprend au moins certains parmi des nanotubes de carbone, des nanotubes de nitrure de bore, des nanotubes de bore, des nano-fibres de bore, des nano-tiges de silicium, des nanotubes de nitrure d'aluminium, et des nano-fibres de nitrure d'aluminium.

15. Interface thermique selon la revendication 14, dans laquelle :
la première couche de métal (20) comprend au moins l'un de l'or, l'argent, le bismuth, le cuivre, l'étain, le germanium, le cadmium, l'indium et le zinc ; et
la deuxième couche de métal (30) comprend au moins l'un de l'or, l'argent, le bismuth, le cuivre, l'étain, le germanium, le cadmium, l'indium et le zinc, la deuxième couche étant différente, d'un métal différent de la première couche.

16. Interface thermique selon la revendication 13, comprenant en outre une troisième couche de métal comprenant le même métal que la première couche de métal (20), le troisième métal étant déposé sur la source de chaleur, et la deuxième couche de métal (30) entre les première (20) et troisième couches de métal.
